# EUROPEAN PATENT APPLICATION

(11) **EP 1 277 675 A1**
(43) Date of publication of application: **22.01.2003**
(21) Application number: 01000304.4
(22) Date of filing: 18.07.2001
(51) Int. Cl.: B65G 13/071, B65G 47/54, B65G 39/02

(54) **Handling and positioning of printing plates**

(71) Applicant: Glunz & Jensen A/S, 4100 Ringstead (DK)
(72) Inventor: Hammersma, Frans, Stuston, Suffolk IP 21 4AB (GB); Bos, Jan, 9561 DP, Ter Apel (NL)
(74) Representative: Harrison, Ivor Stanley

(57) **Abstract**

A ball transfer unit (10) for handling printing plates comprises a housing (11), a conveyor ball (17), at least three sustaining means (20) for sustaining the conveyor ball, biasing means (23) for biasing the sustaining means against the conveyor ball, and means for driving (24) the conveyor ball. A ball transfer conveyor (30) comprising a plurality of such ball transfer units (31-35).

In a method for handling a printing plate, during a step of driving at least one of a first shaft (25) and a second shaft (26), a resultant direction (39) of transferring the printing plate (4) is changed. Further, in a method for handling and positioning a printing plate, an accuracy of position is obtained such that punching may be done.

## Description

### FIELD OF THE INVENTION

The present invention relates to a method and an apparatus for automatically handling a sheet of imaging material.
More specifically the invention is related to processing a printing plate. Even more in particular, the invention is related to transferring a printing plate to an imager or to a processor, optionally combined with a registration punching of the printing plate.

### BACKGROUND OF THE INVENTION

Lithographic printing presses use a so-called printing master such as a printing plate which is e.g. mounted on a cylinder of the printing press. The master carries a lithographic image on its surface and a print is obtained by applying ink to said image and then transferring the ink from the master onto a receiver material, which is typically paper. In conventional lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called driographic printing, the lithographic image consists of ink-accepting and ink-abhesive (ink-repelling) areas and during driographic printing, only ink is supplied to the master.

In recent years the so-called 'computer-to-plate' (CTP) method has gained a lot of interest. This method, also called 'direct-to-plate', bypasses the creation of film because a digital document is transferred directly to a plate precursor by means of a so-called platesetter.

Especially thermal plates, which are sensitive to heat or infrared light, are widely used in computer-to-plate and computer-to-press methods because of their daylight stability. Such thermal materials preferably comprise a compound that converts absorbed light into heat. The heat, which is generated on image-wise exposure, triggers a (physico-)chemical process, such as ablation, polymerisation, insolubilisation by cross-linking of a polymer, decomposition, or particle coagulation of a thermoplastic polymer latex, and after optional processing, a lithographic image is obtained.

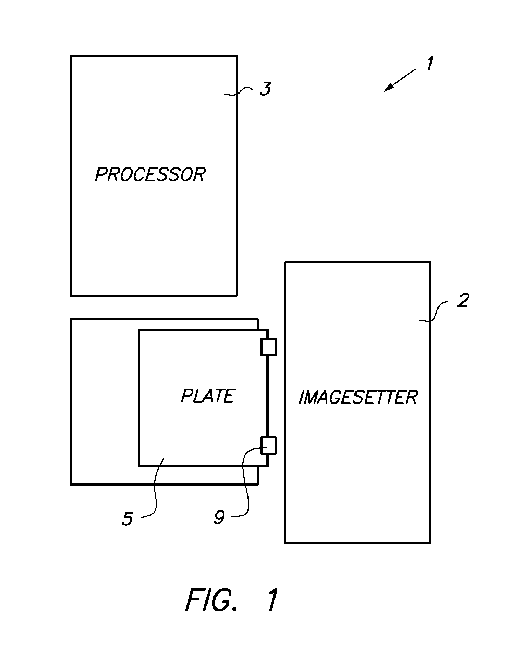

In order to produce a lithographic printing plate, a printing plate precursor thus has to be (i) imagewise exposed and (ii) developed. As an example, figure 1 shows an imaging system suitable for use of the present invention. Herein, a printing plate 5 is imaged in an imager 2 - e.g. imagesetter or platesetter XCALIBUR ™ (of Agfa-Gevaert)- , and processed in a processor 3 - e.g. Autolith TP85 ™ (of Agfa-Gevaert).

Generally, thereafter, the finished printing plate is transferred and secured to a plate cylinder of a printing press (not shown). Then, printed images (sometimes called "printings") can be made.

For the purpose of reproducibility of the printings, it is required that (i) a good "registration" of the image on the printing plate is guaranteed, as well as (ii) a good "registration" of the printing plate to printing press references. Hereto, on the printing plate so-called "registration indicia" - located outside the image boundaries but having a predetermined relation to the image on the printing plate - are commonly used. These indicia may comprise blocks, lines, crosses, deformations, holes or notches.

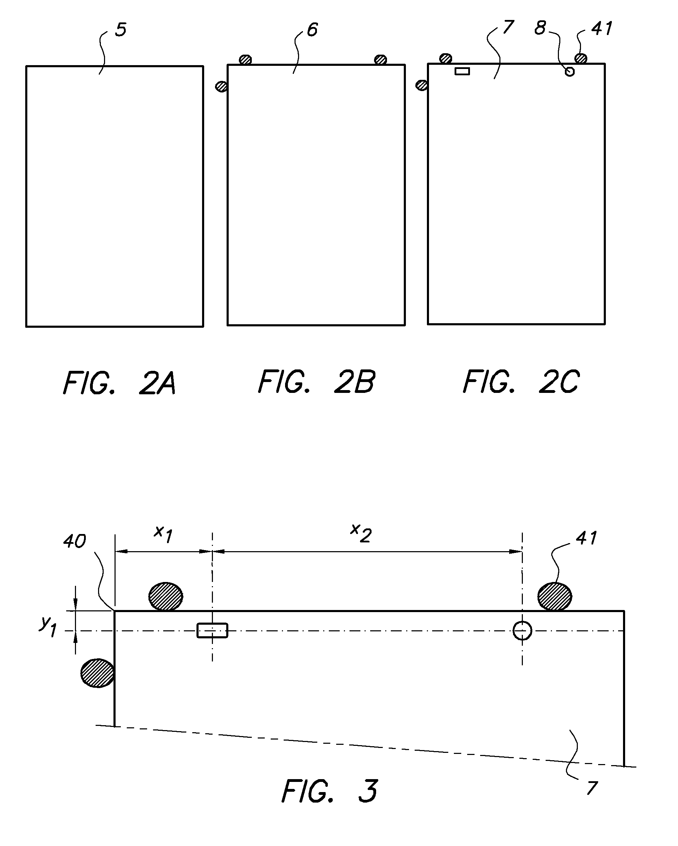

For sake of clarity, figures 2A to 2C schematically show respectively a printing plate 5, an unperforated printing plate 6 in contact with three plate stops, and a perforated printing plate 7 in contact with three plate stops or registration pins 41.

In a suitable embodiment, the perforating apparatus 9 comprises means which permit the printing plate to take a reproducible position, and self-adjusting perforating units with punches and corresponding photocells. For sake of clarity, attention may be drawn on figure 3 which shows an example of a perforated printing plate 7 in punch position (positioned against three registration pins 41), just after punching, thus defining precisely a registration edge 40 (see also reference distances x₁, x₂ and y₁).

Therefor, in the abovementioned figure 1, a printing plate 5 is first imaged in an imager 2, then punched by means of punching heads 9, and then processed in a processor 3.

For monochromic printing, a registration tolerance of +/- 0.5 mm may be accepted.

However, for polychromatic or colour printing, a printing plate must be made for each colour (say Y, M, C, K) and the different colour plates are printed in sequence. Hence, a much finer registration tolerance is required to guarantee that the superimposed printed colour images produce an acceptable final picture. The registration in this case must be better than +/- 0.03 mm (or 30 µm).

Up to now, there still exists a general need for a method and a system able to transport a printing plate from one device (e.g. an imager) to another device (e.g. a processor as described in USP 5,455,651) in different directions and to be able to punch registration holes into the printing plate using the same transport system.
In practical terms, there still exists a need for a method and a system able to transport and position printing plates (over short distances) so that (i) the transport direction is changeable during transport, and so that (ii) the positioning has an accuracy of +/-0.01 mm (or 10 µm).

### OBJECTS OF THE INVENTION

It is an object of the present invention to provide a solution to the above problems of transferring.
Other objects and advantages of the present invention will become apparent from the detailed description.

### SUMMARY OF THE INVENTION

The above mentioned objects of transferring are realised by an apparatus and a method having the specific features defined in independent claims 1, 4, and 6.
Specific features for preferred embodiments of the invention are set out in the dependent claims.

### BRIEF DESCRIPTION OF THE DRAWINGS

The invention will be described by the following illustrative embodiments with reference to the accompanying drawings, which are not necessarily to scale, without the intention to limit the invention thereto, and in which:
Figure 1 shows an imaging system suitable for use of the present invention;
Figures 2A to 2C schematically show respectively a printing plate, an unperforated printing plate in contact with three plate stops, and a perforated printing plated in contact with three plate stops;
Figure 3 shows an example of a perforated printing plate in punch position (positioned against three plate stops), just after punching;
Figure 4 shows a front view of a ball transfer unit according to the present invention;
Figure 5 shows a top view of a ball transfer unit according to the present invention;
Figure 6 shows some ball transfer units arranged along a transporting plane;
Figure 7A to 7D show the movement of a conveyor ball when the driving shafts rotate individually;
Figures 7E to 7K show the movement of a conveyor ball when the driving shafts rotate at the same time and with the same speed;
Figure 8 shows a top view of a ball transfer conveyor;
Figures 9A to 9F show principle top views illustrating how a printing plate can be transported in different directions;
Figure 10A shows an exploded view of a preferred embodiment of a ball transfer unit according to the present invention;
Figure 10B shows an exploded view of a preferred embodiment of a ball transfer conveyor according to the present invention;
Figure 10C shows a preferred embodiment of a sustaining means according to the present invention;
Figure 10D shows an enlarged view of a contact zone between a sustaining means and a conveyor ball.

### DETAILED DESCRIPTION OF THE INVENTION

While the present invention will hereinafter be described in connection with preferred embodiments thereof, it will be understood that it is not intended to limit the invention to those embodiments.

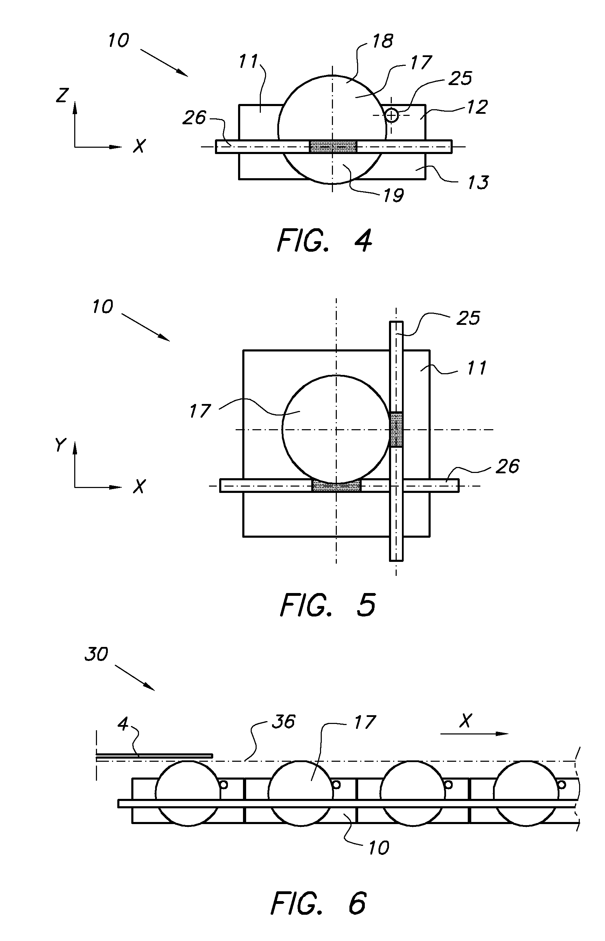

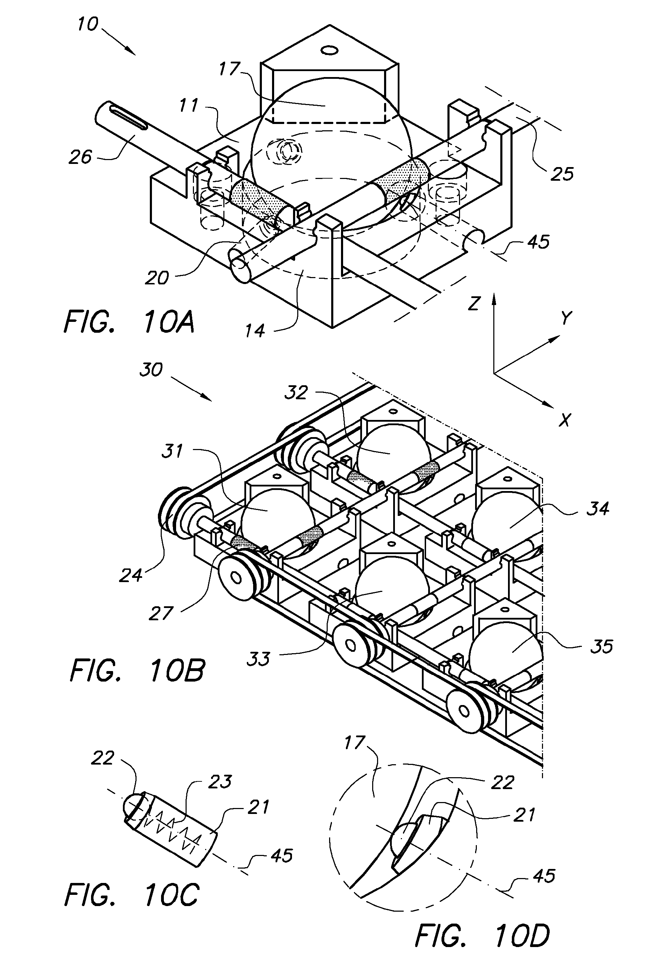

First, reference is made to Figs. 4, 5 and 10A.
Herein, figure 4 shows a front view of a ball transfer unit according to the present invention; figure 5 shows a top view of a ball transfer unit according to the present invention; and figure 10A shows an exploded view of a preferred embodiment of a ball transfer unit according to the present invention.
As one may see from these drawings, in a first embodiment of the present invention, a ball transfer unit 10 comprises a housing 11, a conveyor ball 17, at least three sustaining means 20 for sustaining said conveyor ball, biasing means 23 for biasing said sustaining means against said conveyor ball, and means for driving 24 said conveyor ball.

A first characteristic difference versus known state of the art of ball transfer units (cf. patents USP 5,516,211 of Barnes, and USP 5,540,314 of Coelln) is that said conveyor ball 17 is driven. A second difference is that said housing 11 does not include a semispherical concave mounting surface nor any hemispherical cup. Thirdly, said conveyor ball 17 is sustained by sustaining means 20, preferably using a plunger 21 (e.g. with a mechanical, a peumatic or a hydraulic spring system).

First shaft 25 and second shaft 26 have a driving section 27.
For people skilled in the art, it may be clear that this section should have suitable friction properties to contribute to the rotation of the conveyor ball 17. This driving section 27 may be covered with a layer (e.g. a rubber, a polymer, or a fabric) having a reasonable friction coefficient. Alternatively, the driving section 27 may be formed by a special machining of the peripheral surface (e.g. by a special knurling or by grinding a suitable surface roughness).

In a second embodiment of a ball transfer unit 10 according to the present invention, a first portion 18 (see Fig. 4) of said conveyor ball 17 protrudes out of said housing 11. For example, said ball transfer unit 10 may be placed horizontally, with said first portion 18 at the upper side.

In another embodiment, said housing 11 preferably comprises an opening or aperture 14 (see Fig. 10A) in a second (e.g. bottom) part 13 such that a second (e.g. a lower) portion 19 of said conveyor ball 17 protrudes out of said housing 11. Said opening 14 provides additional possibilities for a reliable operation and maintenance of the system, e.g. in case of cleaning, draining of humidity, removing of dust, etc.

In a further embodiment of a ball transfer unit 10 according to the present invention, said means for driving 24 (see Figs. 10A and 10B) said conveyor ball 17 comprise a first shaft 25 and a second shaft 26 which are substantially orthogonal to each other.

It has to be remarked that in some circumstances, said first shaft 25 and said second shaft 26 are not necessarily strictly orthogonal.

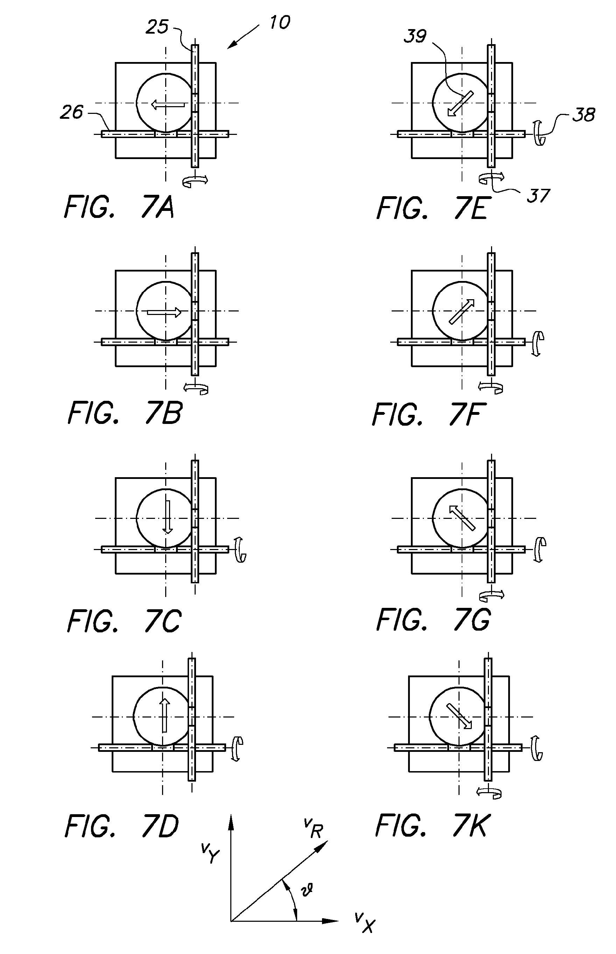

Now, reference is made tot Figs. 7A-7K. Figures 7A to 7D show the movement of a conveyor ball 17 when the driving shafts 25, 26 rotate individually. Figures 7E to 7K show the movement of a conveyor ball 17 when the driving shafts 25, 26 rotate at a same time and with a same speed.

According to known state of the art, an exposed printing plate precursor may be transferred to a processor by means of a so-called bridge (see e.g. USP 5,932,394). Yet, there still exists a need for a system able to transport and position printing plates so that (i) the transport direction is changeable during transport, and so that (ii) the positioning has an accuracy of +/- 0.01 mm (or 10 µm).

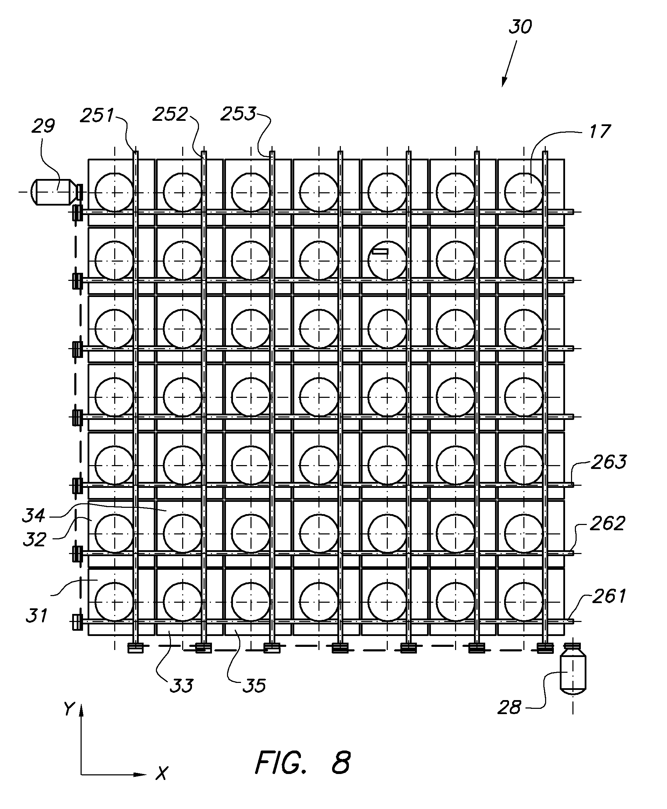

Another aspect of the present invention thus provides a ball transfer conveyor 30 comprising a plurality of ball transfer units 31-35 as indicated hereabove (see Figs. 6, 8 and 10B). Herein Figure 8 shows a top view of a ball transfer conveyor (drive shafts 251, 252, 253 etc are driven by motor 28; drive shaft 261, 262, 263 etc are driven by motor 29); and Figure 10B shows an exploded view of a preferred embodiment of a ball transfer conveyor according to the invention.

The means for driving 24 further may comprise V-shaped belts, flat belts, toothed belts, or cables.

Further, said motors 28, 29 may comprise a stepper-motor, preferentially with an impulse generator; or another kind of electromotor, preferentially with a brake; and an appropriate monitoring system, optionally inspection means (e.g. a video system).

5) Now we look to figure 6, showing some ball transfer units arranged along a transporting plane 36. In a further embodiment of a ball transfer conveyor 30 according to the invention, said first portions 18 of said plurality of ball transfer units 31-35 define a plane, preferably a flat plane 36. By doing so, said conveyor balls 17 contact the material 4, e.g. a printing plate 5, to be transferred.

It has to be remarked that in some circumstances, said first portions 18 of said plurality of ball transfer units 31-35 do not necessarily define a strictly flat plane 36. Optionally, such transporting plane may be inclined or even slightly curved.

From another point of view, the present invention also comprises a method for transferring a material 4 using a ball transfer unit 10 or a ball transfer conveyor 30 as disclosed hereabove.

Preferably, a method according to the present invention, comprises a step of driving at least one of said first shaft 25 and said second shaft 26.

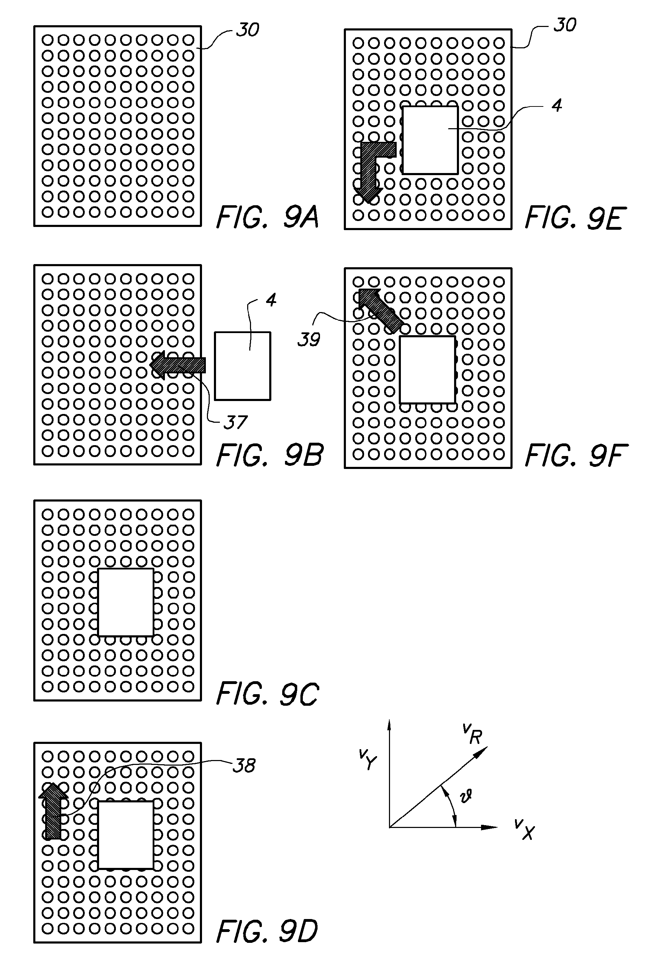

Even more particularly, in a method according to the present invention, a resultant direction 39 of transferring said material 4 is defined by Arctg θ = v_{Y} / v_{X}.
This may be clearly seen from Figs. 7A to 7K and from Figs. 9A to 9F, wherein figures 9A to 9F show principle top views illustrating how a printing plate can be transported in different directions.

If both drive shafts 25, 26 are driven with a same speed, the resultant transport angle θ of the conveyor ball 17, and hence of the imaging material 4 will be 45 degrees. If the speeds v_{X} and v_{Y} of the two drive shafts 25, 26 are not equal, the resultant transport angle θ of the drive ball will change.

Still more preferably, during said step of driving at least one of said first shaft 25 and said second shaft 26, a resultant direction 39 of transferring said material 4 is changed.

In general, in a method according to the present invention, said material 4 to be transferred is an imaging material, preferably a sheetlike imaging material, more preferably a printing plate.

The printing plate to be processed in accordance with the invention can be based on any suitable dimensionally stable material such as paper; plastics such as polyester, vinyl, polyethylene, polyurethane or similar; metals such as copper, aluminum, stainless steel, steel or iron alloys or similar; rubbers such as silicone rubber; carbon fiber reinforced polymers or mixtures or combinations of these materials.

The present invention also comprises a printing plate handler using a ball transfer unit according to the present invention.

### FURTHER APPLICABILITY OF THE PRESENT INVENTION

The present invention results in a precise transport and a good registration of the image to the edges of the printing plate, as well as to printing press references.

The instant invention is particularly advantageous when used in relation to large format plates (e.g. related to the printing of posters). For example, plates up to 820 mm x 1130 mm may be processed in a 'Galileo-system' (available from Agfa-Gevaert).

Further, the instant invention may be applied as well on silver-halogenid-printing plates, as on so-called thermal printing plates, as on polymer printing plates, as on direct thermal plates.

The invention may also be applied to printing plates not having an image.

The present invention also may be applied to linear transporting without punching of a packet of printing plates, a linear transporting without punching of singular plates (as e.g. printed circuit boards PCB's, or optical filters), etc.

In general, the present invention also may be applied to any handler of sheetlike materials by using a ball transfer unit as described hereabove.

In some conditions (e.g. in case of a non-horizontal transporting plane), a retaining ring and/or a cover may be wise to include into the ball transfer unit.

Having described in detail preferred embodiments of the current invention, it will now be apparent to those skilled in the art that numerous modifications can be made therein without departing from the scope of the invention as defined in the appending claims.

### Parts list

- 1.: imaging system
- 2.: imagesetter
- 3.: processor
- 4.: material to be transferred
- 5.: printing plate
- 6.: unperforated printing plate
- 7.: perforated printing plate
- 8.: punch hole
- 9.: notching head
- 10.: ball transfer unit
- 11.: housing
- 12.: first part of housing
- 13.: second part of housing
- 14.: opening (aperture)
- 17.: conveyor ball
- 18.: first part of conveyor ball
- 19.: second part of conveyor ball
- 20.: sustaining means
- 21.: plunger
- 22.: sustaining ball
- 23.: biasing means
- 24.: driving means
- 25.: first shaft (e.g. 251, 252, 253 ...)
- 26.: second shaft (e.g. 261, 262, 263 ...)
- 27.: driving section
- 28.: first electromotor
- 29.: second electromotor
- 30.: ball transfer conveyor
- 31- 35.: plurality of ball transfer units
- 36.: transporting plane
- 37.: first transporting direction
- 38.: second transporting direction
- 39.: resultant transporting direction
- 40.: registration edge
- 41.: registration pin
- 45.: centreline of sustaining means

## Claims

1. A ball transfer unit (10) comprising a housing (11), a conveyor ball (17), at least three sustaining means (20) for sustaining said conveyor ball, biasing means (23) for biasing said sustaining means against said conveyor ball, and means for driving (24) said conveyor ball.

2. A ball transfer unit (10) according to claim 1, wherein a first portion (18) of said conveyor ball (17) protrudes out of said housing (11).

3. A ball transfer unit (10) according to claim 1, wherein said means for driving (24) said conveyor ball (17) comprise a first shaft (25) and a second shaft (26) which are substantially orthogonal to each other.

4. A ball transfer conveyor (30) comprising a plurality of ball transfer units (31-35) according to anyone of the preceding claims.

5. A ball transfer conveyor (30) according to claim 4, wherein said first portions (18) of said plurality of ball transfer units (31-35) define a flat plane (36).

6. A method for transferring a material (4) using a ball transfer conveyor (30) according to anyone of the claims 4-5.

7. A method according to claim 6, comprising a step of driving at least one of said first shaft (25) and said second shaft (26).

8. A method according to claim 7, wherein a resultant direction (39) of transferring said material (4) is defined by Arctg θ = v_{Y} / v_{X}.

9. A method according to claim 7, wherein during said step of driving at least one of said first shaft (25) and said second shaft (26), a resultant direction (39) of transferring said material (4) is changed.

10. A method according to anyone of the claims 6-9, wherein said material (4) to be transferred is an imaging material, preferably a printing plate.
